(19) **Europäisches Patentamt**

**European Patent Office**

**Office européen des brevets**

(11) Numéro de publication : **0 335 769 B1**

(12) **FASCICULE DE BREVET EUROPEEN**

(45) Date de publication du fascicule du brevet :
23.12.92 Bulletin 92/52

(51) Int. Cl.$^5$ : **C03C 17/245**, C03C 17/34, C03C 17/25

(21) Numéro de dépôt : **89400769.9**

(22) Date de dépôt : **20.03.89**

(54) **Verre électroconducteur et procédé pour sa fabrication.**

(30) Priorité : **30.03.88 JP 77885/88**

(43) Date de publication de la demande :
**04.10.89 Bulletin 89/40**

(45) Mention de la délivrance du brevet :
**23.12.92 Bulletin 92/52**

(84) Etats contractants désignés :
**BE CH DE ES FR GB IT LI LU NL SE**

(56) Documents cités :
EP-A- 0 071 865
EP-A- 0 204 563
FR-A- 2 391 966
US-A- 3 415 677
JOURNAL OF THE ELECTROCHEMICAL
SOCIETY, vol. 128, no. 12, décembre 1981,
pages 2684-2686, Manchester, New Hampshire, US; A.P.ROTH et al.: "Semiconducting
zinc oxide films prepared by metal organic
chemical vapor deposition from diethyl zinc"

(56) Documents cités :
THIN SOLID FILMS, vol. 102, no. 1, avril 1983,
pages 1-46, Elsevier Sequoia, Lausanne, CH;
K.L. CHOPRA et al.:
"Transparentconductors-A status review"

(73) Titulaire : **SAINT-GOBAIN VITRAGE
INTERNATIONAL**
18, avenue d'Alsace
F-92400 Courbevoie (FR)

(72) Inventeur : **Hirata, Masahiro**
8 Dosho-machi 4-Chome
Higashi-ku Osaka-shi (JP)
Inventeur : **Kawahara, Hideo**
8 Dosho-machi 4-Chome
Higashi-ku Osaka-shi (JP)
Inventeur : **Misonou, Masao**
8 Dosho-machi 4-Chome
Higashi-ku Osaka-shi (JP)

(74) Mandataire : **Luziau, Nelly et al**
Saint Gobain Recherche 39, Quai Lucien
Lefranc BP 135
F-93303 Aubervilliers Cédex (FR)

## Description

La présente invention concerne un verre électroconducteur comprenant un substrat en verre trempé et une couche transparente électroconductrice comprenant principalement de l'oxyde de zinc.

Depuis quelques années, on utilise comme supports de différents afficheurs, piles solaires et aussi comme surfaces chauffantes, des verres électroconducteurs formés d'un substrat en verre et d'une couche transparente électroconductrice composée principalement d'oxyde de zinc, de cadmium, d'indium, d'étain, etc... En outre, par suite de leur propriété de réflexion du rayonnement infra-rouge, ces verres à couches transparentes électroconductrices sont très utilisés comme verres de protection contre la chaleur, d'autant plus qu'ils conservent cependant un coefficient de transmission satisfaisant dans le domaine visible du spectre solaire.

Ces verres électroconducteurs, pour être utilisables d'une manière satisfaisante, doivent être mécaniquement résistants.

Pour fabriquer des verres électroconducteurs ayant une bonne résistance mécanique, il est particulièrement avantageux d'utiliser, comme substrat, du verre trempé, c'est-à-dire un verre précontraint, formé par une trempe à l'air du verre chauffé à une température proche de son point de ramollissement (650°C à 700°C)ou bien par trempe chimique, c'est-à-dire traitement dans un sel alcalin chauffé et fondu.

Il existe de nombreuses méthodes pour déposer des couches transparentes électroconductrices sur ces substrats en verre. Ces méthodes sont fonction notamment des matières premières utilisées.

Ainsi, une couche transparente électroconductrice comprenant principalement de l'oxyde de zinc est généralement obtenue par pulvérisation cathodique.

Par contre, une couche transparente électroconductrice comprenant principalement de l'oxyde d'étain est généralement obtenue en projetant, sur la surface de verre portée à une température élevée, mais inférieure au point de ramollissement, un composé d'étain organique ou minéral susceptible de se décomposer sous l'effet de la chaleur au contact du verre et de s'oxyder pour former la couche d'oxyde d'étain. Pour un tel dépôt par décomposition thermique, on peut utiliser la méthode CVD (Chemical Vapor Deposition) consistant à mettre, au contact du verre chauffé, le composé métallique sous forme de vapeur obtenue par chauffage et vaporisation ou bien la méthode de pulvérisation qui consiste à pulvériser, sur la surface du verre chauffé, une solution du composé métallique dans un solvant organique. On peut aussi utiliser la méthode dans laquelle on projette sur le substrat chauffé le composé métallique en poudre, en suspension dans un courant gazeux.

Ces couches présentent de bonnes propriétés, notamment de conduction électrique et de transmission de la lumière visible. Cependant, ces couches ont une résistance mécanique qui peut être insuffisante suivant l'utilisation souhaitée.

En effet, si des couches transparentes électroconductrices d'oxyde d'étain sont déposées par la méthode de décomposition thermique sur du verre trempé, il est nécessaire de chauffer le verre trempé à une température élevée, de 500°C à 700°C, pour obtenir le dépôt des couches avec un bon rendement et cela peut entraîner une diminution de la contrainte superficielle du verre. On ne peut alors obtenir un verre électroconducteur présentant une bonne résistance mécanique.

Un procédé de fabrication d'un verre électroconducteur est connu de FR-A-2 391 966 qui divulgue une méthode pour déposer l'oxyde d'étain sur un substrat en verre trempé par décomposition thermique.

Dans le cas des couches transparentes électroconductrices d'oxyde de zinc, déposées par pulvérisation cathodique, sur du verre trempé, le problème de la diminution de la résistance mécanique ne se pose pas car on peut obtenir le dépôt des couches avec un bon rendement sans chauffer le verre trempé à une température élevée. Cependant, la couche d'oxyde de zinc obtenue n'est pas thermiquement stable. En outre, comme la vitesse de dépôt de la couche est faible, (environ 0,01 $\mu$m/mn), le verre électroconducteur obtenu n'a pas de caractéristiques stables, notamment la conductivité électrique évolue dans le temps.

D'autre part, cette méthode de dépôt pose des problèmes lors d'une production en série.

La présente invention a donc pour objet un verre électroconducteur qui présente une forte résistance mécanique et un procédé pour sa fabrication qui puisse être réalisable pour une production en série.

Le verre électroconducteur, selon l'invention, comprend un substrat en verre et une couche transparente électroconductrice d'oxyde métallique. Il est caractérisé en ce que le substrat est en verre trempé et la couche comprend principalement de l'oxyde de zinc déposé par la méthode de décomposition thermique.

Le procédé, selon l'invention, pour former, sur un substrat de verre trempé, une couche transparente électroconductrice d'oxyde métallique consiste à projeter au moins un composé du zinc sur la surface de verre trempé chauffé à une température comprise entre 200°C et 200°C ou 300°C, obtenant ainsi la décomposition thermique du composé au contact du verre et la formation d'une couche d'oxyde de zinc adhérant à la surface du verre.

Au dessin, donné à titre d'exemple :
- la figure 1, représente un schéma en coupe d'un verre électroconducteur selon l'invention, formé d'un support en verre (1) trempé et d'une couche (2) transparente électroconductrice comprenant principalement de l'oxyde de zinc.

- la figure 2, donne les valeurs de la contrainte superficielle (kg/cm²) en fonction de la température (°C) de traitement du substrat en verre trempé à l'air pour des verres électroconducteurs selon l'invention et pour un verre témoin,

- la figure 3, donne les valeurs de contrainte à la rupture (kg/cm²) en fonction de la température (°C) de traitement du substrat en verre trempé chimiquement pour des verres électroconducteurs selon l'invention et pour un verre témoin.

Le substrat en verre est constitué par du verre ayant subi un traitement de trempe chimique ou de trempe à l'air obtenue par des procédés bien connus.

Comme composés du zinc, utilisables pour la mise en oeuvre de l'invention, on peut citer les composés qui sont thermiquement décomposables à une température comprise entre 200°C et 500°C, par exemple, les composés $(CH_3)_2$ Zn, $(C_2H_5)_2$ Zn, Zn Cl$_2$, $(C_2H_3O_2)_2$ Zn, $(C_5H_7O_2)_2$ Zn.

A ces composés du zinc, on peut ajouter, en quantité inférieure à celle du composé de zinc, des composés qui permettent de modifier les caractéristiques de la couche, et notamment d'augmenter la conductivité électrique. On peut citer par exemple des composés des éléments des groupes III A et IV A de la Table de Mendeleiev et notamment des composés de l'aluminium et de l'indium, comme $(CH_3)_3$ Al, $(C_2H_5)_3$ Al, AlCl$_3$, $(C_2H_3O_2)_3$ Al, $(C_5H_7O_2)_3$ Al et $(CH_3)_3$ In, $(C_2H_5)_3$ In, InCl$_3$, $(C_5H_7O_2)_3$ In. On obtient alors des couches d'oxydes de zinc dopées à l'aluminium ou à l'indium.

Il est aussi possible de doper les couches d'oxyde de zinc avec un ou plusieurs des éléments tels que le gallium, le silicium et l'étain, utilisés sous forme de traces.

Afin d'éviter la diffusion des ions alcalins contenus dans le substrat en verre vers la couche électroconductrice, on peut déposer sur le substrat une couche de bioxyde de silicium qui sert de couche intermédiaire entre le verre et la couche électroconductrice.

Pour obtenir les couches d'oxyde d'étain sur la surface du verre trempé, on peut utiliser les méthodes de CVD ou de pulvérisation, telles qu'elles ont été définies précédemment, c'est-à-dire que les matières premières, composés du zinc et le ou les dopants, quand on en utilise, sont projetées sous forme de vapeur ou de gouttes minuscules sur la surface du verre chauffé à une température comprise entre 200°C et 300°C ou 400°C, la température limite étant en fonction du traitement de trempe subi par le substrat. On peut aussi utiliser des matières premières en poudre et les projeter sous forme de suspension dans un courant gazeux, sur le substrat chauffé.

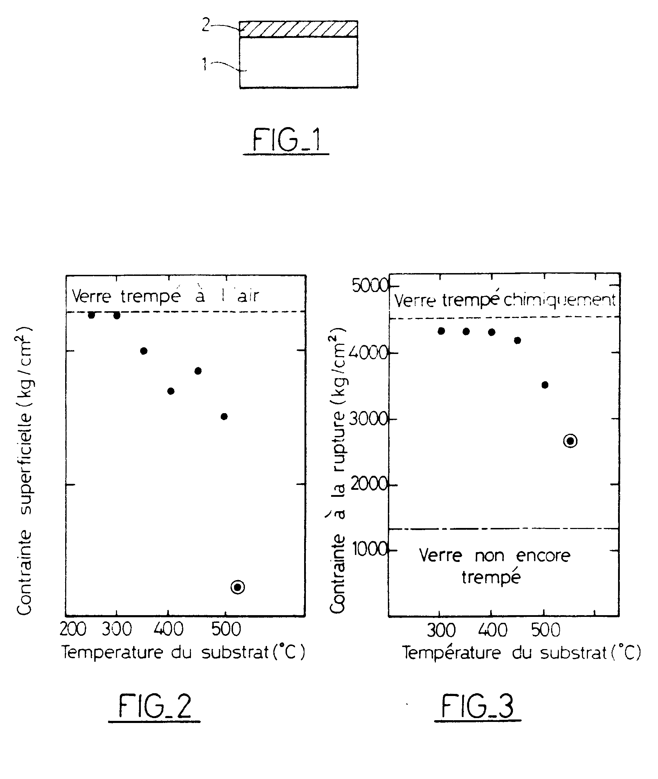

Les verres électroconducteurs selon l'invention, outre leurs propriétés de conduction de l'électricité et de transmission de la lumière, présentent une forte résistance mécanique, du fait que, même après le traitement thermique pour le dépôt de la couche d'oxyde de zinc, le substrat en verre conserve ses caractéristiques initiales, comme le montrent les figures 2 et 3.

Les exemples suivants, non limitatifs, illustrent l'invention.

EXEMPLE 1

Dans une plaque de verre flotté d'une épaisseur de 3,2 mm, ayant subi une trempe à l'air froid, on découpe 6 échantillons, ayant chacun une dimension de 150 x 300 mm. On lave et on sèche ces échantillons. On dépose, sur ces échantillons, utilisés comme substrats, une couche transparente électroconductrice formée principalement d'oxyde de zinc, par la méthode CVD.

Pour cela, on projette sur les substrats chauffés chacun à une température différente, comprise entre 250 et 500°C, un mélange gazeux comprenant de la vapeur de diéthyl-zinc $((C_2H_5)_2$ Zn), de la vapeur d'eau, de l'oxygène et de la vapeur de triéthylindium $((C_2H_5)_3$ In) et de l'argon comme gaz porteur, à raison :

- de 10 cm³/mn de $(C_2H_5)_2$ Zn,
- de 1 cm³/mn de $(C_2H_5)_3$ In,
- de 500 cm³/mn d'argon,
- de 100 cm³/mn d'oxygène, et
- de 0 à 1 cm³/mn d'eau.

Les dépôts ont lieu à une vitesse correspondant à une augmentation d'épaisseur comprise entre 0,05 et 0,1 µm/mn sous une pression de 100 Torr (13300 Pa). On obtient des couches d'oxyde de zinc dopé à l'indium, ayant une épaisseur de 0,6 µm.

La résistance superficielle des couches est de 10 Ω par carré et la transmission moyenne du rayonnement visible est de 75 %.

Pour évaluer la résistance mécanique des verres électroconducteurs obtenus, on mesure la contrainte superficielle des échantillons par la méthode bien connue de la mesure de contrainte par la réflexion totale. Pour que les verres électroconducteurs soient résistants mécaniquement, la contrainte superficielle du verre ne doit pas ou peu varier.

Ces valeurs de contrainte sont déterminées après chauffage des échantillons, portant la couche d'oxyde de zinc, à une température de 300°C pendant 30 mn, puis refroidissement à température ambiante.

La figure 2 donne les contraintes superficielles des différents échantillons, en fonction de la température des substrats lors du dépôt des couches électroconductrices.

Pour les échantillons dont le support de verre a été chauffé jusqu'à 300°C pour le dépôt par CVD, on n'a pas pu observer de variation de la contrainte superficielle, ni celle des autres caractéristiques des couches.

Pour des températures du substrat, lors du dépôt, supérieures à 300°C, on remarque que la contrainte superficielle diminue, mais elle reste cependant à un niveau suffisant pour que le produit présente encore une résistance mécanique utile.

A noter que, avant le dépôt de la couche d'oxyde, la contrainte superficielle du verre non trempé est de 0 kg/cm² et celle du même verre trempé à l'air est de 1150 kg/cm² ; cette dernière valeur est représentée en traits discontinus à la figure 2.

On peut constater que les verres électroconducteurs selon l'invention chauffés jusqu'à 300°C pour le dépôt de la couche d'oxyde, ont une contrainte superficielle pratiquement égale à celle du verre trempé initial.

EXEMPLE 2

A titre de comparaison, on dépose, par la méthode CVD de l'exemple 1, sur un échantillon de verre trempé à l'air comme à l'exemple 1, une couche d'oxyde d'étain dopé au fluor.

La température du substrat en verre trempé, pendant le dépôt, est de 520°C. On obtient une couche dont l'épaisseur est de 0,6 μm, la résistance superficielle de 10 Ω par carré et la transmission moyenne du rayonnement visible de 73 %.

On mesure, comme à l'exemple 1, la contrainte superficielle du verre électroconducteur ainsi obtenu. Comme on peut le voir sur la figure 2, la contrainte, indiquée par le symbole ⊙ , est pratiquement nulle, ce qui indique que ce verre n'a qu'une très faible résistance mécanique.

EXEMPLE 3

On utilise, dans cet exemple, du verre sodocalcique de 1,1 mm d'épaisseur ainsi subi une trempe chimique.

On découpe 5 échantillons de dimension 100 x 100 mm. On les lave et on les sèche.

On dépose, sur ces échantillons de verre trempé chimiquement, une couche transparente électroconductrice d'oxyde de zinc dopé à l'aluminium, par la méthode de pulvérisation d'une solution du composé du zinc et du composé de l'aluminium.

Pour cela, on projette, sur les substrats de verre chauffés chacun à une température différente, comprise entre 300°C et 500°C, une composition comprenant de l'acétate de zinc (Zn (C$_2$H$_3$O$_2$)$_2$) et de chlorure d'aluminium (AlCl$_3$) dans un mélange d'eau et de méthanol (1 : 3 en volume). La composition contient 1 mole/l d'acétate de zinc et 0,1 mole/l de AlCl$_3$. Les dépôts ont lieu à une vitesse correspondant à une augmentation d'épaisseur comprise entre 0,1 et 0,2 μm/mn en utilisant un pulvérisateur, disponible dans le commerce, et de l'air comprimé comme gaz porteur.

Les couches obtenues ont une épaisseur de 0,6 μm. Elles ont une résistance superficielle de 10 Ω par carré et la transmission moyenne du rayonnement visible est de 76 %.

Pour déterminer leur résistance mécanique, on soumet ces échantillons à un essai de résistance à la flexion en utilisant l'appareil "Autographe" de type IS-10 T fabriqué par Shimazu. Les valeurs de la contrainte à la rupture obtenues (en kg/cm²) en fonction des températures auxquelles ont été soumis les échantillons lors du dépôt de la couche d'oxyde, sont données à la figure 3.

Avant la mesure, les échantillons sont chauffés à 300°C pendant 30 mn et refroidis à la température ambiante.

On peut noter que, pour les échantillons chauffés jusqu'à 400°C pour le dépôt de la couche électroconductrice, la contrainte à la rupture et les caractéristiques des couches ne varient pas.

Pour des températures du substrat, lors du dépôt, supérieures à 450°C, la contrainte à la rupture diminue, mais elle reste cependant à un niveau suffisant pour que le produit présente une résistance mécanique utile.

A noter que, avant le dépôt de la couche d'oxyde, la contrainte à la rupture du verre non trempé, est de 1330 kg/cm², et celle de ce verre trempé chimiquement est de 4530 kg/cm² (les traits discontinus sur la figure 3).

On peut donc constater que les verres électroconducteurs selon l'invention chauffés, lors du dépôt, à une température pouvant atteindre 400°C ont une contrainte à la rupture proche (environ 95 %) de celle du verre trempé initial.

EXEMPLE 4

A titre de comparaison, on dépose, par le même procédé que celui décrit à l'exemple 3, une couche transparente électroconductrice d'oxyde d'étain dopé au fluor sur un substrat de verre trempé chimiquement comme à l'exemple 3. La température du substrat, au cours du dépôt, est de 550°C. On obtient une couche dont l'épaisseur est 0,6 μm, la résistance superficielle de 10 Ω par carré et la transmission moyenne du rayonnement visible de 70 %.

Comme à l'exemple 3, on soumet le verre électro conducteur obtenu au test de résistance à la flexion. La valeur de la contrainte à la rupture obtenue pour ce verre témoin est indiquée sur la figure 3 par la symbole ⊙ . Comme on peut le constater, la contrainte à la rupture du verre témoin est très inférieure à celle du substrat de verre trempé chimiquement initial.

**Revendications**

1. Procédé de fabrication d'un verre électroconducteur comprenant un substrat en verre trempé muni d'une couche transparente électroconductrice caractérisé en ce qu'on dépose par une technique de décomposition thermique et oxydation la couche électroconductrice, à base d'oxyde de zinc dopé à l'aide d'un des éléments Al, Ga, In, Si, Sn à partir de composés de zinc et d'un desdits éléments au moins, sur le substrat trempé à l'air et chauffé à une température comprise entre 200 et 300°C dont le niveau de contrainte n'est pratiquement pas affecté par ledit dépôt.

2. Procédé selon la revendication 1, caractérisé en ce qu'on utilise un substrat trempé à l'air d'une épaisseur d'environ 3,2 mm ayant, avant dépôt, une contrainte superficielle de 1150 kg/cm², contrainte conservée inchangée après dépôt.

3. Procédé de fabrication d'un verre électroconducteur comprenant un substrat en verre trempé muni d'une couche transparente électroconductrice caractérisé en ce qu'on dépose par une technique de décomposition thermique et oxydation la couche électroconductrice à base d'oxyde de zinc dopé à l'aide d'un des éléments Al, Ga, In, Si, Sn à partir de composés de zinc et d'un desdits éléments au moins, sur le substrat trempé chimiquement chauffé à une température comprise entre 200 et 400°C, celui-ci conservant au moins environ 95 % du niveau de contrainte qu'il avait avant le dépôt.

4. Procédé selon la revendication 3, caractérisé en ce qu'on utilise un substrat trempé chimiquement d'une épaisseur d'environ 1,1 mm ayant, avant dépôt, une contrainte à la rupture de 4530 kg/cm².

5. Procédé selon l'une des revendications précédentes, caractérisé en ce qu'on dépose entre le substrat trempé et 351a couche électroconductrice une couche intermédiaire de SiO₂.

6. Procédé selon l'une des revendications précédentes, caractérisé en ce qu'on effectue ultérieurement au dépôt de la couche électroconductrice un traitement thermique du substrat à 300°C avant mesure des contraintes mécaniques.

7. Procédé selon l'une des revendications précédentes, caractérisé en ce que les composés de zinc et du(des) élément(s) sont projetés lors du dépôt de la couche électroconductrice sous forme liquide ou gazeuse.

8. Verre électroconducteur présentant les caractéristiques de ceux obtenus par le procédé selon l'une des revendications précédentes, caractérisé en ce qu'il présente une résistance électrique surfacique d'environ 10 ohms/carré.

**Patentansprüche**

1. Verfahren zur Herstellung eines elektrisch leitenden Glases, das ein mit einer transparenten, elektrisch leitenden Schicht versehenes und vorgespanntes Glassubstrat umfaßt, dadurch gekennzeichnet, daß man mittels thermischer Zersetzung und Oxidation die elektrisch leitende Schicht auf Basis von mit Hilfe eines der Elemente Al, Ga, In, Si und Sn dotiertem Zinkoxid ausgehend von Verbindungen des Zinks und wenigstens eines dieser Elemente auf das mit Luft gehärtete und auf eine Temperatur zwischen 200 und 300° C erhitzte Substrat aufbringt, dessen Spannungsniveau durch diese Aufbringung praktisch nicht beeinflußt wird.

2. Verfahren nach Anspruch 1, dadurch gekennzeichnet, daß man ein mit Luft gehärtetes Substrat einer Dicke von ungefähr 3,2 mm einsetzt, das vor der Aufbringung eine Oberflächenspannung von 1.150 kg/cm² aufweist, wobei die Spannung nach der Aufbringung unverändert beibehalten wird.

3. Verfahren zur Herstellung eines elektrisch leitenden Glases, das ein mit einer transparenten, elektrisch leitenden Schicht versehenes und vorgespanntes Glassubstrat umfaßt, dadurch gekennzeichnet, daß man mittels thermischer Zersetzung und Oxidation die elektrisch leitende Schicht auf Basis von mit Hilfe eines der Elemente Al, Ga, In, Si und Sn dotiertem Zinkoxid ausgehend von Verbindungen des Zinks und wenigstens eines dieser Elemente auf das chemisch gehärtete und auf eine Temperatur zwischen 200 und 400° C erhitzte Substrat aufbringt, das wenigstens etwa 95 % seines Spannungsniveaus, das es vor der Aufbringung gehabt hat, behält.

4. Verfahren nach Anspruch 3, dadurch gekennzeichnet, daß man ein chemisch gehärtetes Substrat einer Dicke von ungefähr 1,1 mm einsetzt, das vor der Aufbringung eine Hochspannung von 4.530 kg/cm² aufweist.

5. Verfahren nach einem der vorstehenden Ansprüche, dadurch gekennzeichnet, daß man zwischen dem gehärteten Substrat und der elektrische leitenden Schicht eine SiO₂-Zwischenschicht aufbringt.

6. Verfahren nach einem der vorstehenden Ansprüche, dadurch gekennzeichnet, daß man nach der Aufbringung der elektrisch leitenden Schicht eine thermische Behandlung des Substrats bei 300° C vor der Messung der mechanischen Spannung vornimmt.

7. Verfahren nach einem der vorstehenden Ansprüche, dadurch gekennzeichnet, daß die Verbindungen des Zinks und des/der Elements/e zur Aufbringung der elektrisch leitenden Schicht in flüssiger oder gasförmiger Form versprüht werden.

8. Elektrisch leitendes Glas mit den Eigenschaften, wie sie mit den Verfahren nach einem der vorstehenden Ansprüche erhalten werden, dadurch gekennzeichnet, daß es einen elektrischen Widerstand an der Oberfläche von etwa 10 Ohm/Karree aufweist.

**Claims**

1. Method of manufacturing an electrically conducting glass comprising a substrate of toughened glass provided with an electrically conducting transparent film, characterized in that the electrically conducting film, based upon zinc oxide doped with one of the elements Al, Ga, In, Si, Sn is deposited by a thermal decomposition and oxidation technique from compounds of zinc and at least one of said elements onto the air-toughened substrate heated to a temperature of from 200 to 300°C, the stress level of which is virtually not affected by said deposition.

2. Method according to Claim 1, characterized in that an air-toughened substrate with a thickness of approximately 3.2 mm having, before deposition, a surface stress of 1,150 kg/cm$^2$, which stress remains unchanged after deposition, is used.

3. Method of manufacturing an electrically conducting glass comprising a toughened glass substrate provided with an electrically conducting transparent film, characterized in that the electrically conducting film, based upon zinc oxide doped with one of the elements Al, Ga, In, Si, Sn, is deposited by a thermal decomposition and oxidation technique from compounds of zinc and at least one of said elements onto the chemically toughened substrate heated to a temperature of from 200 to 400°C, this substrate retaining at least approximately 95% of the stress level which it had before the deposition.

4. Method according to Claim 3, characterized in that a chemically toughened substrate of approximately 1.1 mm thickness having, before deposition, a breaking stress of 4,530 kg/cm$^2$ is used.

5. Method according to one of the preceding Claims, characterized in that an intermediate film of $SiO_2$ is deposited between the toughened substrate and the electrically conducting film.

6. Method according to one of the preceding Claims, characterized in that a thermal treatment of the substrate at 300°C is carried out after the deposition of the electrically conducting film and before the mechanical stresses are measured.

7. Method according to one of the preceding Claims, characterized in that the compounds of zinc and of the element or elements are projected during the deposition of the electrically conducting film in liquid or gaseous form.

8. Electrically conducting glass having the characteristics of those obtained by the method according to one of the preceding Claims, characterized in that it has a surface electrical resistance of approximately 10 ohms/square.

FIG_1

FIG_2

FIG_3